# EUROPEAN PATENT SPECIFICATION

(11) **EP 1 892 285 B1**
(45) Date of publication and mention of the grant of the patent: **06.01.2010**
(21) Application number: 07114451.3
(22) Date of filing: 16.08.2007
(51) Int. Cl.: C11D 11/00, C11D 3/37, C11D 17/06, H01L 21/306, H05K 3/26

(54) **Cleaning composition, cleaning method, and manufacturing method of semiconductor device**
Reinigungszusammensetzung, Reinigungsverfahren und Herstellungsverfahren für ein Halbleiterbauelement
Composition de nettoyage, procédé de nettoyage, et procédé de fabrication d'un dispositif à semi-conducteur

(30) Priority: 21.08.2006 JP 2006224759
(43) Date of publication of application: 27.02.2008
(73) Proprietor: JSR Corporation, Tokyo 104-8410 (JP)
(72) Inventor: Andou, Michiaki, Tokyo Tokyo 104-8410 (JP); Konno, Tomohisa, Tokyo Tokyo 104-8410 (JP); Shida, Hirotaka, Tokyo Tokyo 104-8410 (JP); Uchikura, Kazuhito, Tokyo Tokyo 104-8410 (JP); Kurashima, Nobuyuki, Tokyo Tokyo 105-8001 (JP); Minamihaba, Gaku, Tokyo Tokyo 105-8001 (JP); Tateyama, Yoshikuni, Tokyo Tokyo 105-8001 (JP); Yano Hiroyuki, Tokyo Tokyo 105-8001 (JP)
(74) Representative: TBK-Patent

(56) References cited:
- US-A1- 2003 109 413
- US-A1- 2005 176 606

## Description

### BACKGROUND OF THE INVENTION

### 1. Field of the Invention

The present invention relates to a cleaning composition, cleaning method, and manufacturing method of semiconductor devices. More specifically, the present invention relates to a cleaning composition that can suitably be used for cleaning semiconductor substrates that have been chemically mechanically polished, particularly those having a low dielectric constant film inferior in mechanical strength to a silica dielectric film and a metal wiring, and the invention relates to a cleaning method using the cleaning composition, and manufacturing method of semiconductor devices including a step of cleaning semiconductor substrates by the cleaning method after the semiconductor substrates have been chemically mechanically polished.

### 2. Description of the Related Art

A chemical-mechanical polishing technology has been adopted as a planarization technology in manufacturing semiconductor devices. The chemical-mechanical polishing is a technology in which a body to be polished is crimped onto a polishing pad and the body to be polished is chemically and mechanically polished by causing the body to be polished and the polishing pad to slide alternately while supplying a chemical mechanical polishing dispersion onto the polishing pad. Here, the chemical mechanical polishing dispersion usually contains abrasive grains and various chemicals such as etching agents and complexing agents. Thus, abrasive grains and/or polishing waste may remain on a polished surface after polishing. If a wiring made of ametallicmaterial is present on a polished surface, contamination of the polished surface after polishing may occur unavoidably when metal ions chemically drawn out of the polished surface by action of chemicals in the chemical mechanical polishing dispersion are re-adsorbed onto the polished surface.

In recent years, with extremely higher integration of semiconductor devices, even contamination resulting from a trace amount of impurities may significantly affect device performance and, as a result, product yields. Low dielectric constant films are finding increased use in response to higher integration, but low-permittivity materials usually contain organic ingredients in their structure and have a hydrophobic surface. Therefore, impurities such as residual abrasive grains, residual polishing waste, and metal ions are more likely to be adsorbed on a low-permittivity film. Consequently, contamination control tighter than ever before has been demanded.

One example of such contamination control is cleaning of a polished surface after polishing, and decontamination methods of the polished surface using various cleaning agents have been proposed.

For decontamination of a dielectric film after chemical-mechanical polishing, for example, a cleaning method using a cleaning agent containing hydrofluoric acid or ammonia has been proposed (See "Hydrogen Peroxide Solutions for Silicon Wafer Cleaning", RCA Engineer, 28 (4), p9 (1983) and "Clean Solutions Based in Hydrogen Peroxide for Use in Silicon Semiconductor Technology", RCA Review, 31, p187 (1970)). However, a cleaning agent containing hydrofluoric acid corrodes metallic materials and thus cannot be applied to semiconductor substrates having a metal wiring. Moreover, since a cleaning agent containing ammonia corrodes copper in particular, such a cleaning agent cannot be applied to copper wiring boards, which are mainstream in recent years.

A cleaning agent containing citric acid as a primary ingredient, on the other hand, has been proposed as a cleaning agent that does not corrode metallic materials (See Japanese Patent Application Laid-Open No. 10-72594 and Semiconductor World, No. 3, p92 (1997)). However, such a cleaning agent does not have sufficient decontamination capability and does not meet requirements of tight contamination control in recent years.

Also, a cleaning composition containing organic polymer particles having a crosslinked structure and a surfactant has been proposed as a cleaning agent that does not corrode metallic materials and has sufficient decontamination capability (See Japanese Patent Application Laid-Open No. 2005-255983). However, when semiconductor substrates having a low dielectric constant film are cleaned using such a cleaning composition, the low dielectric constant film sometimes exhibits reduced electric characteristics or is mechanically damaged.

In view of circumstances described above, there has been a demand for a cleaning agent that does not corrode metallic materials, particularly copper, and has sufficient decontamination capability meeting requirements of tough contamination control in recent years for new low-permittivity dielectric materials.

### SUMMARY OF THE INVENTION

The present invention is directed to solving the problems involved in conventional technologies as described above. It is therefore an object of the invention to provide a cleaning composition that can decontaminate a surface of a chemically mechanically polished semiconductor substrate having a metal wiring and a low dielectric constant film and can highly remove impurities such as residual abrasive grains, residual polishing waste, and metal ions on the metal wiring and low dielectric constant film without corroding the metal wiring, degrading electric characteristics of the low dielectric constant film, and causing mechanical damage to the low dielectric constant film. Another object of the present invention is to provide a cleaning method that can efficiently decontaminate a polished surface of a chemically mechanically polished semiconductor substrate as described above. Still another object of the present invention is to provide a method of manufacturing a high-quality semiconductor device without contamination by impurities and the like.

As a result of intensive study to achieve the above obj ects, the present inventors have found that the above objects can be achieved by a cleaning composition that contains organic polymer particles having a crosslinked structure with a specific average dispersed particle diameter and a complexing agent. The present invention has been completed based on the finding.

That is, a cleaning composition according to the present invention which is used after chemical-mechanical polishing comprises organic polymer particles (A) having a crosslinked structure with an average dispersed particle diameter of 10 nm or more and less than 100 nm and a complexing agent (B).

Preferably, the complexing agent (B) is at least one complexing agent selected from the group consisting of organic acids and amino compounds. More preferably, the complexing agent (B) is at least one complexing agent selected from the group consisting of oxalic acid, malonic acid, succinic acid, tartaric acid, citric acid, ethylenediaminetetraacetic acid, ethylenediaminetetra(methylenephosphonic acid), nitrilotris(methylenephosphonic acid), salts of these acids, glycine, alanine, ethylenediamine, triethanol amine, and ammonia.

Preferably, the organic polymer particles (A) have at least one functional group selected from the group consisting of a carboxyl group, hydroxyl group, amino group, sulfonic acid group, and -N⁺R₃ (wherein R represents a hydrogen atom or an alkyl group with one to four carbon atoms). Preferably, the organic polymer particles (A) comprise a copolymer of an unsaturated monomer containingacarboxylgroup (a1), amultifunctionalmonomer (a2), and an unsaturated monomer (a3) other than the monomers (a1) and (a2).

Further preferably, the unsaturated monomer containing a carboxyl group (a1) is (meth) acrylic acid, the multifunctional monomer (a2) is at least one multifunctional monomer selected from the group consisting of divinyl benzene, ethylene glycol dimethacrylate, trimethylol propane tri(meth)acrylate, and pentaerythritol triacrylate, and the unsaturated monomer (a3) is at least one unsaturated monomer selected from the group consisting of styrene, α-methylstyrene, methyl (meth) acrylate, cyclohexyl (meth)acrylate, and phenyl (meth)acrylate.

Preferably, the cleaning composition according to the present invention further comprises a surfactant (C). Preferably, the surfactant (C) is at least one surfactant selected from the group consisting of ammonium lauryl sulfate, dodecylbenzenesulfonic acid, potassium dodecylbenzenesulfonate, ammonium dodecylbenzenesulfonate, tetramethylammonium dodecylbenzenesulfonate, potassium alkylnaphthalenesulfonate, and polyoxyethylene lauryl ether.

Preferably, the cleaning composition according to the present invention further comprises a dispersant (D). Preferably, the dispersant (D) is at least one dispersant selected from the group consisting of poly(meth)acrylic acid and salts thereof, acrylic acid-methacrylic acid copolymer and salts thereof, polyvinyl alcohol, polyvinylpyrrolidone, and hydroxyethyl cellulose.

A cleaning method of a semiconductor substrate according to the present invention comprises cleaning a semiconductor substrate that has been chemically mechanically polished, using the cleaning composition. Preferably, the cleaning is at least one type of cleaning selected from the group of cleaning on a platen, brush scrub cleaning, and roll cleaning.

A manufacturing method of a semiconductor substrate according to the present invention comprises a step of chemically mechanically polishing an untreated semiconductor substrate and a step of cleaning the chemically mechanically polished semiconductor substrate by the cleaning method.

According to the present invention, the cleaning composition can decontaminate a surface of a chemically mechanically polished semiconductor substrate having a metal wiring and a low dielectric constant film and can highly remove impurities such as residual abrasive grains, residual polishing waste, and metal ions on the metal wiring and low dielectric constant film without corroding the metal wiring, degrading electric characteristics of the low dielectric constant film, and causing mechanical damage. The cleaning composition can effectively decontaminate a polished surface of a semiconductor substrate that has been chemically mechanically polished, and enables production of high-quality semiconductor devices without contamination by impurities and the like.

### BRIEF DESCRIPTION OF THE DRAWINGS

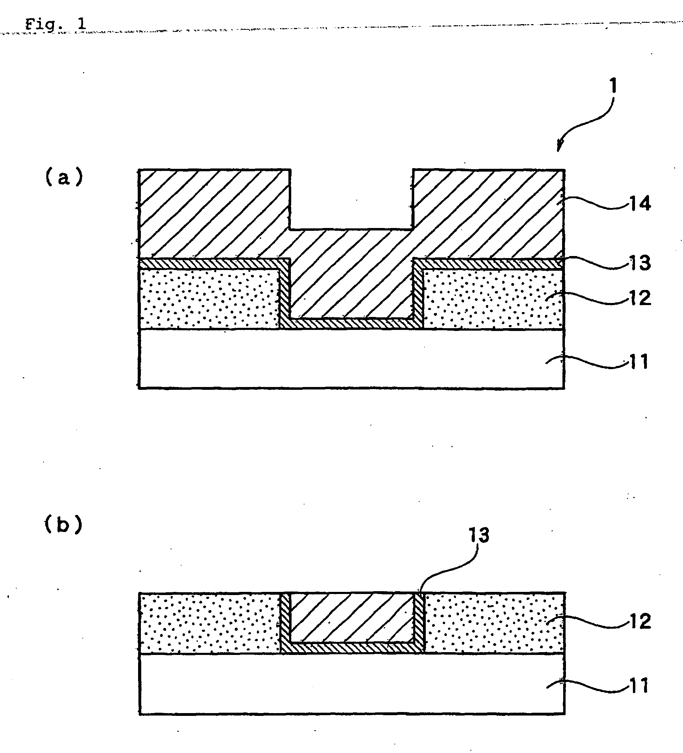

FIG. 1 (a) is a sectional view exemplifying a semiconductor substrate before chemical-mechanical polishing; and
FIG. 1 (b) is a sectional view exemplifying a semiconductor substrate before cleaning.

### DETAILED DESCRIPTION OF THE PREFERRED EMBODIMENT

### [Cleaning composition]

The cleaning composition according to the present invention contains (A) organic polymer particles having a crosslinked structure and (B) a complexing agent, and preferably further contains (C) a surfactant and (D) a dispersant as required.

### (A) Organic polymer particles having a crosslinked structure

The organic polymer particles (A) used in the present invention have a crosslinked structure (hereinafter called "crosslinked organic polymer particles (A)"). By containing the crosslinked organic polymer particles (A), the cleaning composition of the invention shows a capability of removing impurities such as metal ions that is comparable or superior to that of conventionally known cleaning agents, and inhibits surface defects.

The average dispersed particle diameter of the crosslinked organic polymer particles (A) is 10 nm or more and less than 100 nm, preferably 20 to 90 nm, and more preferably 30 to 80 nm. The crosslinked organic polymer particles (A) having this average dispersed particle diameter increase dispersion stability in the cleaning composition, and stable characteristics are maintained for a long period of time. Further, the above average dispersed particle diameter provides an optimal surface area for the particles to act as a physical adsorbent, so that the cleaning composition shows excellent decontamination capability. Thus, the cleaning composition produces cleaning effects comparable to those obtainable with particles whose average diameter exceeds the above range, in a shorter time to enable shorter and more cost competitive cleaning. Further, the cleaning composition can decontaminate a low-permittivity dielectric layer that is inferior in mechanical strength to a silica film being a conventional interlayer dielectric film, without degrading electric characteristics and damaging the shape of the dielectric layer.

Preferably, the crosslinked organic polymer particles (A) contain at least one functional group selected from the group consisting of a carboxyl group, hydroxyl group, amino group, sulfonic acid group, and -N⁺R₃ (wherein R represents a hydrogen atom or an alkyl group with one to four carbon atoms). The crosslinked organic polymer particles (A) having such a functional group show a high capability of removing metal ions as impurities. Among the above functional groups, the carboxyl group and hydroxyl group are preferable and the carboxyl group is more preferable.

Examples of the crosslinked organic polymer particles (A) include particles composed of a copolymer of an unsaturated monomer containing a carboxyl group (a1), a multifunctional monomer (a2), and an unsaturated monomer (a3) other than the monomers (a1) and (a2).

### (a1) Unsaturated monomer containing a carboxyl group

The unsaturated monomer containing a carboxyl group (a1) has a carboxyl group and a polymerizable unsaturated bond. Examples thereof include unsaturated monocarboxylic acids, unsaturated polycarboxylic acids, and mono[(meth)acryloyloxyalkyl]esters of polycarboxylic acids.

The unsaturated monocarboxylic acids include (meth)acrylic acid, crotonic acid, α-chloroacrylic acid, and cinnamic acid.

The unsaturated polycarboxylic acids include maleic acid, maleic anhydride, fumaric acid, itaconic acid, itaconic anhydride, citraconic acid, citraconic anhydride, and mesaconic acid.

The mono[(meth)acryloyloxyalkyl]esters of polycarboxylic acids include mono[2-(meth)acryloyloxyethyl] succinate and mono[2-(meth)acryloyloxyethyl] phthalate.

These unsaturated monomers containing a carboxyl group may be used alone or in combination of two or more kinds. Among the above unsaturated monomers containing a carboxyl group (a1), the unsaturated monocarboxylic acids are preferable and (meth)acrylic acid is more preferable.

### (a2) Multifunctional monomer

The multifunctional monomer (a2) has two or more polymerizable unsaturated bonds. Example of the multifunctional monomers (a2) include divinyl aromatic compounds and poly(meth)acrylates.

The divinyl aromatic compounds include divinyl benzene.

The poly(meth)acrylates include di(meth)acrylates such as diethylene glycol di(meth)acrylate, triethylene glycol di(meth)acrylate, polyethylene glycol di(meth)acrylate, 1, 3-butylene glycol di(meth)acrylate, 1,4-butylene glycol di(meth)acrylate, 1,6-hexane glycol di(meth)acrylate, neopentyl glycol di(meth)acrylate, dipropylene glycol di(meth)acrylate, polypropylene glycol di(meth)acrylate, and 2,2'-bis(4-methacryloxy diethoxyphenyl) propane; tri (meth) acrylates such as trimethylolethane tri (meth) acrylate, tetramethylolmethane tri(meth)acrylate, trimethylolpropane tri (meth) acrylate, and pentaerythritol triacrylate; and tetra- and higher functional acrylates such as tetramethylolmethane tetraacrylate.

These multifunctional monomers may be used alone or in combination of two or more kinds. Among the above multifunctional monomers (a2), the divinyl aromatic compounds, di(meth)acrylate, and tri(meth)acrylate are preferable, and divinyl benzene, ethylene glycol dimethacrylate, trimethylolpropane tri(meth)acrylate, and pentaerythritol triacrylate are more preferable.

### (a3) Unsaturated monomer other than the monomers (a1) and (a2)

The unsaturated monomer (a3) is other than the unsaturated monomer containing a carboxyl group (a1) and the multifunctional monomer (a2) and has at least one polymerizable unsaturated bond. Examples of the unsaturated monomers (a3) include aromatic vinyl compounds, unsaturated carboxylates, aminoalkyl esters of unsaturated carboxylic acids, unsaturated amides,and aliphatic conjugated dienes.

The aromatic vinyl compounds include styrene, α-methyl styrene, o-vinyl toluene, m-vinyl toluene, p-vinyl toluene, p-chlorstyrene, o-methoxystyrene, m-methoxystyrene, p-methoxystyrene, o-vinylbenzyl methyl ether, m-vinylbenzyl methyl ether, p-vinylbenzyl methyl ether, o-vinylbenzyl glycidyl ether, m-vinylbenzyl glycidyl ether, and p-vinylbenzyl glycidyl ether.

The unsaturated carboxylates include methyl (meth) acrylate, ethyl (meth) acrylate, n-propyl (meth) acrylate, i-propyl (meth)acrylate, n-butyl (meth)acrylate, i-butyl (meth)acrylate, sec-butyl (meth)acrylate, t-butyl (meth)acrylate, 2-hydroxyethyl (meth)acrylate, 2-hydroxypropyl (meth)acrylate, 3-hydroxypropyl (meth)acrylate,2-hydroxybutyl (meth)acrylate, 3-hydroxybutyl (meth)acrylate, 4-hydroxybutyl (meth)acrylate, allyl (meth)acrylate, benzyl (meth)acrylate, cyclohexyl (meth)acrylate, phenyl (meth)acrylate, 2-methoxyethyl (meth)acrylate, 2-phenoxyethyl (meth)acrylate, methoxydiethyleneglycol (meth)acrylate, methoxytriethyleneglycol (meth)acrylate, methoxypropyleneglycol (meth)acrylate, methoxydipropyleneglycol (meth)acrylate, isobornyl (meth)acrylate, dicyclopentadienyl (meth)acrylate, 2-hydroxy-3-phenoxypropyl (meth)acrylate, and glycerol mono(meth)acrylate.

The aminoalkyl esters of unsaturated carboxylic acids include 2-aminoethyl (meth)acrylate, 2-dimethylaminoethyl (meth)acrylate, 2-aminopropyl (meth)acrylate, 2-dimethylaminopropyl (meth)acrylate, 3-aminopropyl (meth)acrylate, and 3-dimethylaminopropyl (meth)acrylate.

The unsaturated amides include (meth)acrylamide, α-chloroacrylamide, and N-2-hydroxyethyl (meth)acrylamide.

The aliphatic conjugated dienes include 1, 3-butadiene, isoprene, and chloroprene.

These unsaturated monomers may be used alone or in combination of two or more kinds. Among the above unsaturated monomers (a3), the aromatic vinyl compounds and unsaturated carboxylates are preferable, and styrene, α-methyl styrene, methyl (meth)acrylate, cyclohexyl (meth)acrylate, and phenyl (meth)acrylate are more preferable.

The copolymer for the crosslinked organic polymer particles (A) preferably includes 0.5 to 20% by mass of the unsaturated monomer containing a carboxyl group (a1), 1 to 70% by mass of the multifunctional monomer (a2), and 10 to 98.5% by mass of the unsaturated monomer (a3); more preferably 1 to 15% by mass of the unsaturated monomer containing a carboxyl group (a1), 2 to 60% by mass of the multifunctional monomer (a2), and 25 to 97% by mass of the unsaturated monomer (a3); and further preferably 3 to 15% by mass of the unsaturated monomer containing a carboxyl group (a1), 5 to 50% by mass of the multifunctional monomer (a2), and 35 to 92% by mass of the unsaturated monomer (a3).

The copolymer may be produced by conventionally known polymerization methods such as solution polymerization, emulsion polymerization, and suspension polymerization. Polymerization conditions such as the polymerization temperature and polymerization time may be appropriately determined in accordance with the monomers to be copolymerized and copolymer properties such as molecular weight.

### (B) Complexing agent

The complexing agent (B) used in the present invention is capable of being coordinated to metal ions (copper ions in particular) dissolved by the cleaning composition to form a more stable complex. Such complex may be reliably removed.

Examples of the complexing agents (B) include organic acids and salts thereof, and amino compounds. Specific examples include compounds having at least one carboxyl group and salts thereof, for example, monocarboxylic acids such as formic acid, acetic acid, and propionic acid; dicarboxylic acids such as oxalic acid, malonic acid, succinic acid, glutaric acid, adipic acid, pimelic acid, maleic acid, fumaric acid, and phthalic acid; tricarboxylic acids such as trimellitic acid and tricarballylic acid; oxycarboxylic acids such as oxymonocarboxylic acids (for example, hydroxybutyric acid, lactic acid, and salicylic acid), oxydicarboxylicacids (forexample, malic acid and tartaric acid), and oxytricarboxylic acids (for example, citric acid); amino acids such as glycine, alanine, aspartic acid, and glutamic acid; and aminopolycarboxylic acids such as ethylenediamine tetraacetic acid [EDTA] and trans-1,2-diaminocyclohexane tetraacetic acid [CyDTA].

Examples of the complexing agents (B) further include compounds having no carboxyl group, for example, phosphonic acids such as ethylene diamine tetra(methylenephosphonic acid) [EDTPO], ethylenediaminedi(methylenephosphonic acid) [EDDPO], nitrilotris(methylenephosphonic acid) [NTPO] and 1-hydroxyethylidene-1,1'-diphosphonic acid [HEDPO]; condensed phosphoric acids such as tripolyphosphoric acid and hexametaphosphoric acid, and salts thereof; diketones such as acetylacetone and hexafluoroacetylacetone; amines such as ethylenediamine and triethanol amine; ammonia; and inorganic ions such as thiocyanate ions, thiosulfate ions and ammonium ions.

The complexing agents (B) may be used alone or in combination of two or more kinds. Of the organic acids, the compounds having at least one carboxyl group, and the phosphonic acids and salts thereof are preferable, and the dicarboxylic acids, hydroxyl acid, amino acids, and salts thereof are more preferable, and oxalic acid, malonic acid, succinic acid, tartaric acid, citric acid, ethylenediamine tetraacetic acid [EDTA], ethylenediaminetetra(methylenephosphonic acid) [EDTPO], nitrilotris (methylenephosphonic acid) [NTPO], salts thereof, glycine and alanine are particularly preferable. Of the amino compounds, ethylenediamine, triethanol amine, and ammonia are particularly preferable.

### (C) Surfactant

The surfactant (C) used in the present invention is preferably an anionic surfactant or nonionic surfactant.

The anionic surfactants include alkylsulfuric acid esters such as laurylsulfuric acid esters; alkylbenzenesulfonic acids such as dodecylbenzenesulfonic acid; alkylnaphthalenesulfonic acids; sulfates of polyoxyethylene alkyl ethers such as polyoxyethylene lauryl sulfate; naphthalene sulfonic acid condensate; and lignin sulfonic acid. These anionic surfactants may be in the form of salt. Examples of the counter cations include sodium ions, potassium ions, and ammonium ions. Among these ions, potassium ions and ammonium ions are preferable.

The nonionic surfactants include polyoxyethylene alkyl ethers such as polyoxyethylene lauryl ether, polyoxyethylene cetyl ether, polyoxyethylene stearyl ether, and polyoxyethylene oleyl ether; polyoxyethylene aryl ethers such as polyoxyethylene octylphenyl ether and polyoxyethylene nonylphenyl ether; sorbitan fatty acid esters such as sorbitanmonolaurate, sorbitan monopalmitate, and sorbitan monostearate; and polyoxyethylene sorbitan fatty acid esters such as polyoxyethylene sorbitan monolaurate, polyoxyethylene sorbitan monopalmitate, and polyoxyethylene sorbitan monostearate.

The surfactants (C) may be used alone or in combination of two or more kinds. Among the above surfactants (C), the alkylsulfuric acid esters, alkylbenzenesulfonic acids, alkylnaphthalenesulfonic acids, and sulfates of polyoxyethylene alkyl ethers are preferable, and ammonium laurylsulfate, dodecylbenzenesulfonic acid, potassium dodecylbenzenesulfonate, ammonium dodecylbenzenesulfonate, tetramethylammonium dodecylbenzenesulfonate, potassium alkylnaphthalenesulfonates, and polyoxyethylene lauryl ether are more preferable.

### (D) Dispersant

Examples of the dispersants (D) for use in the present invention include polymers of unsaturated carboxylic acids such as poly(meth)acrylic acid and acrylic acid-methacrylic acid copolymer, and salts thereof; and water-soluble macromolecules such as polyvinylalcohols, polyvinylpyrrolidones, and hydroxyethyl cellulose.

The dispersants (D) may be used alone or in combination of two or more kinds. Among the above dispersants (D), poly (meth) acrylic acid is preferable. Poly (meth) acrylic acid readily adsorbs to the residual abrasive grains, residual polishing waste and the like, and these impurities are effectively dispersed in the liquid and removed.

### (E) Dispersion medium

The aforementioned components are dispersed and dissolved in a dispersion medium (E) in the present invention. Examples of the dispersion mediums (E) for use in the present invention include water and mixed media of water and alcohols. The alcohols include methanol, ethanol, and isopropanol.

The dispersion media (E) maybe used alone or in combination of two or more kinds. Among the above dispersion media (E), water is preferably used.

### <pH adjuster>

The cleaning composition according to the present invention may further contain a pH adjuster (F) if necessary.

Examples of the pH adjusters (F) include inorganic acids such as hydrochloric acid, nitric acid, and sulfuric acid; hydroxides of alkali metals such as sodium hydroxide, potassium hydroxide, rubidium hydroxide, and cesium hydroxide; and basic substances such as tetramethylammonium hydroxide (TMAH) and ammonia .

The pH adjusters (F) may be used alone or in combination of two or more kinds. Among these pH adjusters (F), potassium hydroxide, ammonia, and tetramethylammonium hydroxide (TMAH) are preferable, and tetramethylammonium hydroxide (TMAH) ismore preferable.

### <Cleaning composition>

The cleaning composition according to the present invention preferably contains the crosslinked organic polymer particles (A) in an amount of 0.001 to 5.0% by mass, more preferably 0.001 to 1.0% by mass, and further preferably 0.001 to 0.5% by mass. When the content of the crosslinked organic polymer particles (A) is in the above range, the crosslinked organic polymer particles (A) are homogeneously dispersed and the cleaning composition is stable. The cleaning composition preferably contains the complexing agent (B) in an amount of 5% by mass or less, more preferably 0.001 to 3% by mass, and further preferably 0.01 to 3% by mass. When the content of the complexing agent (B) is in the above range, the complexing agent is effectively coordinated to the solubilized metal ions to form a more stable complex and such complex may be reliably removed.

The cleaning composition preferably contains the surfactant (C) in an amount of 0.0001 to 5% by mass, more preferably 0.001 to 1% by mass, and further preferably 0.001 to 0.5% by mass. When the content of the surfactant (C) is in the above range, the cleaning composition is stable with the crosslinked organic polymer particles (A) being homogeneously dispersed, and the cleaning composition sufficiently removes impurities such as abrasive grains and metallic contaminants.

The cleaning composition preferably contains the dispersant (D) in an amount of 5% by mass or less, more preferably 0.001 to 1% by mass, and further preferably 0.01 to 0.5% by mass. When the content of the dispersant (D) is in the above range, residual abrasive grains, residual polishing waste and the like can be efficiently dispersed for removal.

The pH of the cleaning composition according to the present invention is preferably 12 or less, more preferably 2 to 11, and further preferably 2 to 6. The cleaning composition having this pH can sufficiently remove impurities without corroding the metal wiring.

The cleaning composition according to the present invention shall preferably contain the aforesaid components in the above-preferred concentrations when the composition is used. That is, the cleaning composition according to the present invention may directly have the above preferred concentrations of the components, or may be produced in a concentrated form and be diluted with a solvent prior to use so that the concentrations of the components will be in the aforesaid preferred ranges.

The composition in a concentrated form may be prepared by increasing the concentration of each component excluding the solvent so as to maintain the ratio of the above preferable concentrations. In the concentrated composition, the concentration of the crosslinked organic polymer particles (A) is preferably 30% by mass or less, more preferably 15% by mass or less, and the concentration of the complexing agent (B) is preferably 15% by mass or less, more preferably 10% by mass or less. The concentration of the surfactant (C) in the concentrated composition is preferably 15% by mass or less, more preferably 10% by mass or less, and the concentration of the dispersant (D) is preferably 15% by mass or less, more preferably 10% by mass or less. When the concentrations of the components in the concentrated composition are as described above, the concentrated cleaning composition can be stored stably and, even after long-term storage, can be diluted and used to provide desired performance.

### [Cleaning method of semiconductor substrate and manufacturing method of semiconductor device]

In the cleaning method of a semiconductor substrate according to the present invention, a semiconductor substrate that has been chemically mechanically polished is cleaned with the cleaning composition of the present invention. The manufacturing method of a semiconductor device according to the present invention includes a step of chemically mechanically polishing an untreated semiconductor substrate and a step of cleaning the chemically mechanically polished semiconductor substrate by the cleaning method according to the present invention.

Examples of the semiconductor substrates include semiconductor substrates whose surface to be cleaned exposes at least one material selected from a metal material forming a wiring (hereinafter called the "metal wiring material"), a barrier metal, and a dielectric material. Among these materials, the method of the present invention is suited for treating semiconductor substrates whose surface to be cleaned exposes at least a low-permittivity dielectric material.

The metal wiring materials include tungsten, aluminum, copper, and alloys containing at least one of thesemetals. Among these materials, copper and alloys containing copper are suitably treated according to the invention.

The barrier metals include tantalum, tantalum nitride, titanium, titanium nitride, and ruthenium. Among these metals, tantalum and tantalum nitride are suitably treated according to the invention.

The dielectric films include thermally oxidized films, PETEOS films (plasma enhanced TEOS films), HDP films (high density plasma-enhanced TEOS films), silicon oxide films produced by a thermal CVD method, boron phosphorus silicate films (BPSG films), dielectric films called FSG, and low dielectric constant films.

The thermally oxidized films may be manufactured by exposing high-temperature silicon to an oxidizing atmosphere to allow silicon and oxygen or silicon and moisture to react chemically.

The PETEOS films may be manufactured by plasma-enhanced chemical vapor deposition of tetraethylorthosilicate (TEOS).

The HDP films may be manufactured by high-density plasma-enhanced chemical vapor deposition of tetraethylorthosilicate (TEOS).

The silicon oxide films produced by a thermal CVD method may be manufactured by an atmospheric pressure CVD method (AP-CVD method) or low pressure CVD method (LP-CVD method).

The boron phosphorus silicate films (BPSG-films) may be manufactured by an atmospheric pressure CVD method (AP-CVD method) or low pressure CVD method (LP-CVD method).

The dielectric films called FSG may be manufactured by high density plasma-enhanced chemical vapor deposition.

The low dielectric constant films include organic SOG films, hydrogen-containing SOG films, low-permittivity films made of organic macromolecules, SiOF low-permittivity films, and SiOC low-permittivity films. Here, "SOG" is an abbreviation for "spin on glass" and the SOG films are dielectric films formed by coating a substrate with a precursor and heat treating the precursor. The low-permittivity dielectric films available on the market include dielectric films (BD series) by a black diamond process manufactured by Applied Materials Japan Inc. and low dielectric constant films (LKD series) of MSQ type manufactured by JSR Corporation.

The organic SOG film is formed, for example, from silicon oxide containing an organic group such as a methyl group. More specifically, the organic SOG film may be obtained by coating a substrate with a precursor containing a mixture of tetraethoxysilane and methyltrimethoxysilane, and heat treating the precursor.

The hydrogen-containing SOG film is formed from silicon oxide containing a silicon-hydrogen bond. More specifically, the hydrogen-containing SOG film may be obtained by coating a substrate with a precursor containing triethoxysilane or the like and heat treating the precursor.

The low-permittivity films made of organic macromolecules include low-permittivity films containing polyarylene, polyimide, polybenzocyclobutene, or polyethylene fluoride as a main component.

The SiOF low-permittivity film is formed from silicon oxide containing a fluorine atom, and may be obtained, for example, by doping a CVD silicon oxide film with fluorine.

The SiOC low-permittivity film is formed from silicon oxide containing a carbon atom, and may be manufactured, for example, by chemical vapor deposition of a mixture of silicon tetrachloride and carbon monoxide.

Among the low dielectric constant films, the organic SOG films, hydrogen-containing SOG films, and low-permittivity films made of organic macromolecules may have fine pores in the film.

The manufacturing method of a semiconductor device according to the present invention may be applied to any untreated semiconductor substrates having any of the above materials (films) on a surface to be polished. In particular, the manufacturing method is suitably applied to an untreated semiconductor substrate that is a laminate including, in the named order, a substrate made of silicon or the like, a low dielectric constant film having a groove in which a metal wiring will be formed, a barrier metal film on the low dielectric constant film, and a metal wiring material on the barrier metal film. FIG. 1(a) shows an example of a cross section of such a semiconductor substrate. A board 1 shown in FIG. 1 (a) includes a substrate 11 made of for example silicon, a dielectric film 12, a barrier metal film 13, and a metal film 14 forming a wiring.

In the manufacturing method of a semiconductor device according to the present invention, excessive barrier metal and metal wiring material other than in the groove are first removed by a conventionally known chemical-mechanical polishing method.

A chemical mechanical polishing aqueous dispersion used for the chemical-mechanical polishing contains abrasive grains, an organic acid, and an oxidizing agent. Further, an inorganic acid or a complexing agent may be contained as required. The use of an inorganic acid or a complexing agent enables effectively controlling the rate of removing the metal wiring material with respect to the barrier metal material.

The abrasive gains may be conventional. Such abrasive grains include inorganic oxide particles such as silica, ceria, and alumina; organic particles;and organic/inorganic composite particles.

The organic acids include oxalic acid, maleic acid, malic acid, succinic acid, and citric acid. The inorganic acids include nitric acid and sulfuric acid.

The oxidizing agents include hydrogen peroxide and ammonium persulfate.

The complexing agent maybe conventional. Such complexing agents include quinolinic acid, pyridinecarboxylic acid, quinaldic acid, quinolinol, benzotriazole, benzoimidazole, hydroxybenzotriazole, and carboxybenzotriazole.

In the present invention, it is not necessary to use the aqueous polishing dispersion throughout the chemical-mechanical polishing step for removing excessive barrier metal and metal wiring material. The aqueous polishing dispersion shall be suitably used in part of the polishing step, preferably in a final step thereof. When the untreated semiconductor substrate is polished with the above aqueous polishing dispersion that is used in part of the polishing step, preferably in a final step thereof, the cleaning composition used in the subsequent cleaning step can produce sufficient effects.

In the chemical-mechanical polishing step, excessive barrier metal and metal wiring material are removed. The consequent semiconductor substrate has a cross section such as shown in FIG. 1 (b) . As shown, the polished surface exposes the dielectric film 12 and the metal film 14 forming a wiring. On the polished surface, abrasive grains, polishing waste, metal ions, and the like often remain (not shown). The cleaning method according to the present invention is capable of removing such remnants from the surface of the semiconductor substrate using the cleaning composition.

In the cleaning method of the present invention, cleaning may be performed using the cleaning composition of the invention by a conventionally known technique such as cleaning on a platen, brush scrub cleaning, or roll cleaning. In the cleaning method, such known cleaning technique may be conducted only once, or may be repeated two or more times. When the cleaning is performed two or more times, the same cleaning technique may be repeated or different cleaning techniques may be performed. Also, the cleaning may be repeated by the cleaning method using the cleaning composition according to the present invention and a conventionally known cleaning method, for example, a cleaning method using ultra-pure water. In this case, the cleaning method according to the present invention and the conventionally known cleaning method may be carried out in an arbitrary order.

Cleaning conditionsmay be determined appropriately. For example, the cleaning on a platen may be preferably carried out at a head rotation speed of 10 to 150 rpm, more preferably 20 to 100 rpm, at a head load of 5 to 350 g/cm², more preferably 10 to 210 g/cm², at a platen rotation speed of 10 to 150 rpm, more preferably 20 to 100 rpm, at a supply rate of cleaning composition of 50 to 400 mL/min, more preferably 100 to 300 mL/min, and for a cleaning time of 5 to 120 seconds, more preferably 10 to 100 seconds. In a general meaning, the brush scrub cleaning and roll cleaning are methods that clean a semiconductor substrate while holding the semiconductor substrate between two brushes or rolls. The rotation speed of the two brushes or rolls maybe the same or different as required. The cleaning conditions are variable depending on the cleaning device and cleaning unit, but may be similar to cleaning conditions with a general cleaning agent. For example, the brush or roll rotation speed is preferably 10 to 500 rpm, more preferably 30 to 300 rpm, the board rotation speed is preferably 10 to 300 rpm, more preferably 30 to 200 rpm, the supply rate of cleaning composition is preferably 10 to 500 mL/min, more preferably 50 to 300 mL/min, and the cleaning time is preferably 5 to 120 seconds, more preferably 10 to 100 seconds.

### [Examples]

The present invention will be described below with reference to examples, but the present invention is not limited to such examples.

### [A] Preparation of cleaning compositions

### (1) Preparation of water dispersions containing organic polymer particles

### [Preparation Example A1]

A flask was charged with 5 parts by mass of acrylic acid, 10 parts by mass of divinyl benzene, and 85 parts by mass of styrene as monomers, 0.5 parts by mass of ammonium persulfate as a polymerization initiator, 12 parts by mass of dodecylbenzenesulfonic acid as a surfactant, and 400 parts by mass of ion exchanged water as a solvent. Then, the mixture was heated up to 70°C with stirring under a nitrogen atmosphere and was further stirred for 8 hours at the same temperature for polymerization. The polymerization resulted in a water dispersion of organic polymer particles (1) having a carboxyl group and a crosslinked structure with an average dispersed particle diameter of 25 nm (hereinafter called "crosslinked organic polymer particles (1)"). The concentration of the crosslinked organic polymer particles (1) was adjusted to 10% by mass by adding ion-exchanged water to the water dispersion.

### [Preparation Example A2]

A water dispersion of organic polymer particles (2) having a carboxyl group and a crosslinked structure with an average dispersed particle diameter of 50 nm (hereinafter called "crosslinked organic polymer particles (2)") was obtained in the same manner as in Preparation Example A1, except that 5 parts by mass of methacrylic acid, 20 parts by mass of divinyl benzene, and 75 parts by mass of styrene as monomers, and 9 parts by mass of dodecylbenzenesulfonic acid as a surfactant were used. The concentration of the crosslinked organic polymer particles (2) was adjusted to 10% by mass by adding ion-exchanged water to the water dispersion.

### [Preparation Example A3]

A water dispersion of organic polymer particles (3) having a carboxyl group and a crosslinked structure with an average dispersed particle diameter of 100 nm (hereinafter called "crosslinked organic polymer particles (3)") was obtained in the same manner as in Preparation Example A1, except that 5 parts by mass of acrylic acid, 5 parts by mass of divinyl benzene, and 90 parts by mass of styrene as monomers, and 3 parts by mass of dodecylbenzenesulfonic acid as a surfactant were used. The concentration of the crosslinked organic polymer particles (3) was adjusted to 10% by mass by adding ion-exchanged water to the water dispersion.

### [Preparation Example A4]

A water dispersion of organic polymer particles (4) having a carboxyl group and a crosslinked structure with an average dispersed particle diameter of 210 nm (hereinafter called "crosslinked organic polymer particles (4)") was obtained in the same manner as in Preparation Example A2, except that 5 parts by mass of acrylic acid was used instead of methacrylic acid and the amount of dodecylbenzenesulfonic acid was changed to 0.5 parts by mass. The concentration of the crosslinked organic polymer particles (4) was adjusted to 10% by mass by adding ion-exchanged water to the water dispersion.

### [Preparation Example A5]

A water dispersion of organic polymer particles (a) having a carboxyl group and no crosslinked structure with an average dispersed particle diameter of 250 nm (hereinafter called "non-crosslinked organic polymer particles (a)") was obtained in the same manner as in Preparation Example A1, except that 5 parts by mass of acrylic acid and 95 parts by mass of styrene were used as monomers and the amount of dodecylbenzenesulfonic acid was changed to 0.3 parts by mass. The concentration of the non-crosslinked organic polymer particles (a) was adjusted to 10% by mass by adding ion-exchanged water to the water dispersion.

Table 1 shows the monomers and other components used in Preparation Examples A1 to A5.

**[Table 1]**

| | | Preparation Example A1 | Preparation Example A2 | Preparation Example A3 | Preparation Example A4 | Preparation Example A5 |
|---|---|---|---|---|---|---|
| | | Crosslinked organic polymer particles (1) | Crosslinked organic polymer particles (2) | Crosslinked organic polymer particles (3) | Crosslinked organic polymer particles (4) | Non-crosslinked organic polymer particles (a) |
| Monomers | Styrene | 85 | 75 | 90 | 75 | 95 |
| | Acrylic acid | 5 | - | 5 | 5 | 5 |
| | Methacrylic acid | - | 5 | - | - | - |
| | Divinyl benzene | 10 | 20 | 5 | 20 | - |
| Surfactant | Dodecylbenzenesulfonic acid | 12 | 9 | 3 | 0.5 | 0.3 |
| Average dispersed particle diameter (nm) | | 25 | 50 | 100 | 210 | 250 |

| | | | | | | |
|---|---|---|---|---|---|---|
| Unit of mount: Parts by mass -: Indicates that the monomer was not used. | | | | | | |

### (2) Preparation of cleaning compositions

### (2-1) Preparation of cleaning compositions (1) to (9)

A polyethylene vessel was charged with the water dispersion of the crosslinked organic polymer particles as shown in Table 2, in an amount such that the amount of the crosslinked organic polymer particles was as indicated in Table 2. The polyethylene vessel was further charged with a complexing agent, a surfactant, and a dispersant as shown in Table 2 in amounts shown in Table 2. The mixture was stirred for 15 minutes. Ion exchanged water was added to the mixture so that the amount of the system was 100 parts by mass, and the pH was adjusted using a pH regulator shown in Table 2. The mixture was filtered through a filter having a pore size of 5 µm. In this manner, cleaning compositions (1) to (9) were obtained. Table 2 shows the pH of each cleaning composition.

### (2-2) Preparation of cleaning composition (10)

A polyethylene vessel was charged with 0.5 parts by mass of citric acid as a complexing agent and 0.2 parts by mass of dodecylbenzenesulfonic acid as a surfactant. The mixture was stirred for 15 minutes. Ion-exchanged water was added to the mixture so that the amount of the system was 100 parts by mass, and the pH was adjusted with tetramethylammonium hydroxide (TMAH). The mixture was filtered through a filter having a pore size of 5 µm to give a cleaning composition (10). Table 2 shows the pH of the cleaning composition (10).

### (2-3) Preparation of cleaning composition (11)

A polyethylene vessel was charged with the water dispersion of the non-crosslinked organic polymer particles (a) prepared in Preparation Example A5, in an amount of 0.5 parts by mass in terms of the non-crosslinked organic polymer particles. The polyethylene vessel was further charged with 0.1 parts by mass of ethylenediamine tetraacetic acid as a complexing agent, 0.2 parts by mass of dodecylbenzenesulfonic acid as a surfactant, and 0.1 parts by mass of polyacrylic acid as a dispersant. The mixture was stirred for 15 minutes. Ion-exchanged water was added to the mixture so that the amount of the system was 100 parts by mass, and the pH was adjusted with tetramethylammonium hydroxide (TMAH). The mixture was filtered through a filter having a pore size of 5 µm to give a cleaning composition (11). Table 2 shows the pH of the cleaning composition (11).

**[Table 2]**

| Cleaning composition | Organic polymer particles | | Complexing agent | | Surfactant | | Dispersant | | pH adjuster | pH |
|---|---|---|---|---|---|---|---|---|---|---|
| | Type | Amount | Type | Amount | Type | Amount | Type | Amount | Type | |
| (1) | Cross-linked organic polymer particles (2) | 1.0 | Glycine | 0.5 | - | - | - | - | - | 3.0 |
| | | | Ethylenediamine tetraacetic acid | 0.5 | | | | | | |
| (2) | Cross-linked organic polymer particles (1) | 0.1 | Ethylenediamine tetraacetic acid | 0.1 | Dodecylbenzenesulfonic acid | 0.2 | Polyvinyl pyrrolidone | 0.1 | TMAH | 5.0 |
| (3) | Cross-linked organic polymer particles (1) | 0.1 | Glycine | 0.5 | Dodecylbenzenesulfonic acid | 0.2 | Polyacrylic acid | 0.01 | KOH | 4.9 |
| (4) | Cross-linked organic polymer particles (2) | 1.0 | Glycine | 0.02 | Dodecylbenzenesulfonic acid | 0.01 | Polyacrylic acid | 0.1 | TMAH | 4.5 |
| | | | Ethylenediamine tetraacetic acid | 0.1 | | | | | | |
| (5) | Cross-linked organic polymer particles (2) | 0.1 | Ethylenediamine tetraacetic acid | 0.1 | Dodecylbenzenesulfonic acid | 0.1 | Polyacrylic acid | 0.05 | TMAH | 4.5 |
| (6) | Cross-linked organic polymer particles (2) | 0.05 | Glycine | 0.1 | Dodecylbenzenesulfonic acid | 0.2 | Polyacrylic acid | 0.1 | TMAH | 4.1 |
| (7) | Cross-linked organic polymer particles (2) | 0.01 | Oxalic acid | 0.5 | Dodecylbenzenesulfonic acid | 1.0 | Polyacrylic acid | 0.05 | NH₃ | 4.3 |
| | | | Ethylenediamine tetraacetic acid | | | | | | | |
| (8) | Cross-linked organic polymer particles (3) | 0.01 | - | - | - | - | Polyvinyl pyrrolidone | 0.01 | TMAH | 7.0 |
| (9) | Cross-linked organic polymer particles (4) | 0.1 | Glycine | 0.1 | Dodecylbenzenesulfonic acid | 0.2 | Polyacrylic acid | 1.0 | TMAH | 4.6 |
| | | | Ethylenediamine tetraacetic acid | 0.02 | | | | | | |
| (10) | - | - | Citric acid | 0.5 | Dodecylbenzenesulfonic acid | 0.2 | - | - | TMAH | 5.6 |
| (11) | Non-cross linked organic polymer particles | 0.5 | Ethylenediamine tetraacetic acid (a) | 0.1 | Dodecylbenzenesulfonic acid | 0.2 | Polyacrylic acid | 0.1 | TMAH | 4.4 |

| | | | | | | | | | | |
|---|---|---|---|---|---|---|---|---|---|---|
| Unit of mount: Parts by mass -: Indicates that the monomer was not used. | | | | | | | | | | |

### [B] Preparation of chemical mechanical polishing aqueous dispersions

### (1) Preparation of dispersions containing abrasive grains

### [Preparation Example B1]

### (Preparation of water dispersion containing colloidal silica)

70 parts by mass of ammonia water having a concentration of 25% by mass, 40 parts by mass of ion exchanged water, 170 parts by mass of ethanol, and 20 parts by mass of tetraethoxysilane were put in a rotary dispersion device. The mixture was heated up to 60°C with stirring at 180 rpm and was further stirred at 60°C for 2 hours. The mixture was cooled to room temperature. An operation to remove ethanol was repeated several times using a rotary evaporator at 80°C while adding ion-exchanged water. Consequently, a water dispersion containing 20% by mass of colloidal silica was obtained. The average primary particle diameter of colloidal silica contained in the water dispersion was 25 nm and the average secondary particle diameter was 40 nm.

### [Preparation Example B2]

### (Preparation of water dispersion containing fumed alumina)

2 kg of fumed alumina particles (commercial name "Aluminum Oxide C" manufactured by Degussa) were added to 6.7 kg of ion-exchanged water, and the particles were dispersed with use of an ultrasonic dispersing device. The dispersion was filtered through a filter having a pore size of 5 µm to give a water dispersion containing fumed alumina. The average dispersed particle diameter of alumina contained in the water dispersion was 150 nm.

### [Preparation Example B3]

### (Preparation of water dispersion containing fumed silica)

6 kg of ion-exchanged water was put in planetary kneader "T. K. Hivis Disper Mix 3D-20" (manufactured by Primix Corporation). Thereafter, 6 kg of fumed silica particles (manufactured by Nippon Aerosil Co., Ltd., commercial name "Aerosil No. 50", specific surface area measured by the BET (Brunauer-Emmett-Teller) method: 52 m²/g) were continuously added in 30 minutes while rotating a twisted blade at a primary rotational speed of 10 rpm and a secondary rotational speed of 30 rpm. Subsequently, the mixture was kneaded for 1 hour while rotating the twisted blade at a primary rotational speed of 10 rpm and a secondary rotational speed of 30 rpm and while rotating a coreless high-speed rotor with a diameter of 80 mm at a primary rotational speed of 10 rpm and a secondary rotational speed of 2,000 rpm.

Next, 0.3108 g of a 20% by mass aqueous potassium hydroxide solution was added to the resultant mixture, and the mixture was diluted with ion-exchanged water. The diluted mixture was filtered through a depth cartridge filter having a pore size of 5 µm to give a water dispersion containing 30% by mass of fumedsilica. The average dispersed particle diameter of silica contained in this water dispersion was 52 nm.

### [Preparation Example B4]

### (Preparation of water dispersion containing organic abrasive grains)

A flask was charged with 86 parts by mass of methyl methacrylate, 9 parts by mass of styrene, and 5 parts by mass of acrylic acid as monomers, 0.5 parts by mass of ammonium persulfate as a polymerization initiator, 0.5 parts by mass of dodecylbenzenesulfonic acid as a surfactant, and 400 parts by mass of ion-exchanged water as a solvent. Then, the mixture was heated up to 70°C with stirring under a nitrogen atmosphere and was kept at 80°C for 8 hours for polymerization. Consequently, 100% degree of conversion was reached. The polymer dispersion was diluted with ion-exchanged water. As a result, a water dispersion was obtained which contained 10% by mass of organic abrasive grains having an average dispersed particle diameter of 200 nm.

### (2) Preparation of chemical mechanical polishing aqueous dispersions (1) to (5)

A polyethylene vessel was sequentially charged with the water dispersion of the abrasive grains as shown in Table 3 in an amount such that the amount of the abrasive grains was as indicated in Table 3; and an organic acid, a complexing agent and an oxidizing agent as shown in Table 3 in amounts shown in Table 3. The mixture was stirred for 15 minutes. A pH adjuster shown in Table 3 was added to the mixture so that the pH of the final chemical mechanical polishing aqueous dispersion would be as shown in Table 3. Further, ion-exchanged water was added so that the amount of the system was 100 parts by mass. Then, the mixture was filtered through a filter having a pore size of 5 µm. In this manner, chemical mechanical polishing aqueous dispersions (1) to (5) were obtained. Table 3 shows the pH of these aqueous dispersions.

In the aqueous dispersions (4) and (5), fumed silica or colloidal silica, and organic abrasive grains were used together.

**[Table 3]**

| | Abrasive grains | | Organic acid | | Oxidizing agent | | Complexing agent | | pH adjuster | pH |
|---|---|---|---|---|---|---|---|---|---|---|
| | Type | Amount | Type | Amount | Type | Amount | Type | Amount | Type | |
| Aqueous dispersion (1) | Colloidal silica | 5.0 | Maleic acid | 0.6 | Hydrogen peroxide | 0.5 | Quinaldic acid | 0.2 | Potassium hydroxide (solid) | 10.5 |
| Aqueous dispersion (2) | Fumed alumina | 5.0 | Succinic acid | 1.0 | Ammonium persulfate | 4.0 | Benzotriazole | 0.1 | 10% by mass aqueous nitric acid solution | 2.5 |
| Aqueous dispersion (3) | Fumed silica | 5.0 | Maleic acid | 0.5 | Hydrogen peroxide 0.3 | | Quinaldic acid | 0.2 | Potassium hydroxide (solid) | 8.5 |
| Aqueous dispersion (4) | Fumed silica | 1.0 | Citric acid | 0.3 | Hydrogen peroxide | 1.0 | Quinolinic acid | 0.7 | 28% by mass ammonia water | 11.0 |
| | Organic abrasive grains | 0.5 | | | | | | | | |
| Aqueous dispersion (5) | Colloidal silica Organic | 5.0 | Maleic acid | 0.5 | Hydrogen peroxide | 0.5 | Quinaldic acid | 0.2 | Potassium hydroxide (solid) | 10.5 |
| | abrasive grains | 1.0 | | | | | | | | |

| | | | | | | | | | | |
|---|---|---|---|---|---|---|---|---|---|---|
| Amount unit: Parts by mass | | | | | | | | | | |

### [C] Preparation of low dielectric constant film

### (1) Preparation of polysiloxane sol

101.5 g of methyltrimethoxysilane, 276.8 g of methyl methoxypropionate, and 9.7 g of tetraisopropoxytitanium/ethyl acetoacetate complex were mixed, and the mixture was heated up to 60°C. Then, while stirring the mixture, a mixture of 92.2 g of γ-butyrolactone and 20.1 g of water was added dropwise over a period of 1 hour. After the dropwise addition, the mixture was further stirred at 60°C for 1 hour to give a polysiloxane sol.

### (2) Preparation of polystyrene particles

A flask was charged with 100 parts by mass of styrene, 2 parts by mass of an azo polymerization initiator (manufactured by Wako Pure Chemical Industries, Ltd. , commercial name "V60"), 0.5 parts by mass of potassium dodecylbenzenesulfonate, and 400 parts by mass of ion-exchanged water. Then, the mixture was heated up to 70°C with stirring under a nitrogen atmosphere and was kept at the temperature for 6 hours for polymerization. Polystyrene particles whose average particle diameter was 150 nm were thereby obtained.

### (3) Preparation of low dielectric constant film

15 g of the polysiloxane sol obtained in (1) above and 1 g of the polystyrene particles obtained in (2) above were mixed. A silicon board with a thermally oxidized film that was 8 -inches in diameter was coated- with the- resultant mixture by the spin coating method. The coated silicon board was heated in an oven at 80°C for 5 minutes and subsequently at 200°C for 5 minutes. Then, in a vacuum, the silicon board was heated at 340°C for 30 minutes, at 360°C for 30 minutes, at 380°C for 30 minutes, and further at 450°C for 1 hour to produce a board having a colorless, transparent coating film (low dielectric constant film) with a thickness of 2000 Å. Observation of the cross section of the coating film with a scanning electron microscope showed formation of a large number of fine pores. The relative permittivity of this coating film was 1.98, the coefficient of elasticity was 3 GPa, and the percentage of voids was 15%.

### [D] Preparation of metal contaminated board

A solution containing copper ions at 100 ppb concentration was prepared by dissolving copper nitrate in ultra-pure water. An 8-inch p-type silicon wafer (manufactured by Shin-Etsu Handotai Co., Ltd.) was soaked in the solution at 25°C for 30 minutes and was dried with a spin drier to produce a metal contaminated board.

The metal contamination on this board was determined by the total reflection X-ray fluorescence method using "TREX610T" manufactured by TECHNOS Co., Ltd. The determination found that copper atoms were attached at 5×10¹³ atoms/cm² on the board.

### [Example 1]

### (1) Chemical-mechanical polishing and cleaning of dielectric film

### (1-1) Chemical-mechanical polishing

The low-permittivity dielectric film of the board prepared in [C] was chemically-mechanically polished under the following conditions using chemical-mechanical polishing machine "EPO112" (manufactured by Ebara Corporation).

### (Polishing conditions)

Chemical mechanical polishing aqueous dispersion:

### Aqueous dispersion (1)

Polishing pad: "IC1000/SUBA400" manufactured by Rodel

### Nitta Company

Head rotation speed: 70 rpm
Head load: 250 g/cm²
Platen rotation speed: 70 rpm
Supply rate of aqueous dispersion: 300 mL/min
Polishing time: 60 seconds

### (1-2) Cleaning of dielectric film

After the chemical-mechanical polishing in (1-1) described above, the polished surface of the board was cleaned on a platen under the following conditions and was further cleaned by brush scrub cleaning under the following conditions. This will be called "two step cleaning" hereinafter.

### (Cleaning on a platen)

Cleaning agent: Cleaning composition (1)
Head rotation speed: 70 rpm
Head load: 100 g/cm²
Platen rotation speed: 70 rpm
Supply rate of cleaning agent: 300 mL/min
Cleaning time: 30 seconds

### (Brush scrub cleaning)

Cleaning agent: Cleaning composition (1)
Upper brush rotation speed: 100 rpm
Lower brush rotation speed: 100 rpm
Board rotation speed: 100 rpm
Supply rate of cleaning agent: 300 mL/min
Cleaning time: 30 seconds

### (1-3) Evaluation of the polishing rate and surface defect

The thickness of the dielectric film of the board was measured before the chemical mechanical polishing and after the cleaning by meansoflight-interference measuring apparatus "FPT500" (manufactured by SENTEC Corp., Ltd.). The polishing rate was calculated from the thickness difference and the polishing time, resulting in 1,250 Å/min. The whole surface of the dielectric film after cleaning was observed using wafer surface contaminant inspection machine "Surf Scan SP1" (manufactured by KLA-Tencor Corporation), resulting in 9 surface defects/surface. Here, "surface defects" include residual abrasive grains and watermarks (substantially circular discolored portions like "stain spots", though the cause thereof is unknown).

### (2) Cleaning of metal contaminated board

The metal contaminated board prepared in [D] described above was cleaned in two steps using chemical-mechanical polishing machine"EP0112" (manufactured by Ebara Corporation), in the same manner as in "(1-2) Cleaning of dielectric film" described above.

The metal contamination on this cleaned board was determined by the total reflection X-ray fluorescence method using "TREX610T" manufactured by TECHNOS Co., Ltd. The determination found that the residual copper atoms had been reduced to 7×10¹¹ atoms/cm².

### [Examples 2-13 and Comparative Examples 1-7]

### (1) Chemical-mechanical polishing and cleaning of dielectric film

### (1-1) Chemical-mechanical polishing

The dielectric constant film of the board prepared in [C] described above was chemically-mechanically polished in the same manner as in Example 1, except that a chemical mechanical polishing aqueous dispersion listed in Table 4 was used instead of the chemical mechanical polishing aqueous dispersion (1).

### (1-2) Cleaning of dielectric film

After the chemical-mechanical polishing in (1-1) described above, the polished surface of the board was cleaned in two steps in the same manner as in Example 1, except that a cleaning agent listed in Table 4 was used instead of the cleaning composition (1).

### (1-3) Evaluation of the polishing rate and surface defect

The polishing rate and the number of surface defects on the cleaned dielectric film were evaluated in the same manner as in Example 1. The evaluation results are shown in Table 4.

### (2) Cleaning of metal contaminated board

The metal contaminated board prepared in [D] described above was cleaned in two steps in the same manner as in Example 1, except that a cleaning agent listed in Table 4 was used instead of the cleaning composition (1). The metal contamination on the cleaned board was determined in the same manner as in Example 1. The results are shown in Table 4.

Surface defects in Comparative Examples 1 to 5 were caused by residual abrasive grains of the aqueous dispersion. Surface defects in Comparative Examples 6 and 7 were caused by residual non-crosslinked organic polymer particles of the cleaning composition.

**[Table 4]**

| CMP aqueous dispersion | | Cleaning agent | | Polishing and cleaning of dielectric film | | Cleaning of metal contaminated board |
|---|---|---|---|---|---|---|
| | | For cleaning on a platen | For brush scrub cleaning | Dielectric film polishing rate | Number of surface defects after cleaning | Residual copper concentration |
| | | | | (Å/min) | (/surface) | (atom/cm²) |
| Ex. 1 | Aqueous dispersion (1) | Composition (1) | Composition (1) | 1250 | 15 | 5×10¹¹ |
| Ex. 2 | Aqueous dispersion (1) | Composition (2) | Composition (2) | 1250 | 9 | 7×10¹¹ |
| Ex. 3 | Aqueous dispersion (3) | Composition (3) | Composition (3) | 290 | 8 | 4×10¹¹ |
| Ex. 4 | Aqueous dispersion (1) | Composition (3) | Composition (4) | 1250 | 9 | 3×10¹¹ |
| Ex. 5 | Aqueous dispersion (3) | - | Composition (4) | 290 | 12 | 1×10¹¹ |
| Ex. 6 | Aqueous dispersion (1) | Composition (5) | Composition (5) | 1250 | 6 | 7×10¹⁰ |
| Ex. 7 | Aqueous dispersion (4) | Composition (2) | Composition (5) | 100 | 7 | 8×10¹⁰ |
| Ex. 8 | Aqueous dispersion (3) | Composition (6) | Composition (6) | 290 | 10 | 8×10¹⁰ |
| Ex. 9 | Aqueous dispersion (5) | Composition (3) | Composition (6) | 1140 | 8 | 3×10¹¹ |
| Ex. 10 | Aqueous dispersion (2) | Composition (7) | Composition (7) | 510 | 8 | 9×10¹⁰ |
| Ex. 11 | Aqueous dispersion (1) | - | Composition (7) | 1250 | 13 | 6×10¹¹ |
| Ex. 12 | Aqueous dispersion (2) | Composition (4) | Composition (5) | 510 | 6 | 5×10¹¹ |
| Ex. 13 | Aqueous dispersion (3) | Composition (5) | Composition (6) | 290 | 7 | 1×10¹¹ |
| Comp. Ex. 1 | Aqueous dispersion (1) | Composition (9) | Composition (9) | 1250 | 40 | 2×10¹² |
| Comp. Ex. 2 | Aqueous dispersion (2) | - | Composition (9) | 510 | 51 | 7×10¹² |
| Comp. Ex. 3 | Aqueous dispersion (4) | - | Composition (8) | 100 | 200 | 5×10¹² |
| Comp. Ex. 4 | Aqueous dispersion (3) | Composition (10) | Composition (10) | 290 | 357 | 2×10¹² |
| Comp. Ex. 5 | Aqueous dispersion (4) | - | Composition (10) | 100 | 524 | 4×10¹² |
| Comp. Ex. 6 | Aqueous dispersion (4) | Composition(11) | Composition (11) | 100 | 425 | 6×10¹¹ |
| Comp. Ex. 7 | Aqueous dispersion (5) | Composition (10) | Composition (11) | 1140 | 562 | 7×10¹¹ |

### [Example 14]

### (1) Chemical-mechanical polishing and cleaning of patterned board

### (1-1) Chemical-mechanical polishing

A board having a copper-wiring pattern (manufactured by International SEMATECH, model: 854LKD003) was chemically-mechanically polished in two steps under the following conditions using chemical-mechanical polishing machine "EPO112" (manufactured by Ebara Corporation).

### (First step chemical-mechanical polishing)

Chemical mechanical polishing aqueous dispersion:

### Aqueous dispersion (5)

Polishing pad: "IC1000/SUBA400" manufactured by Rodel

### Nitta Company

Platen rotation speed: 70 rpm
Head rotation speed: 70 rpm
Head load: 250 g/cm²
Supply rate of aqueous dispersion: 300 mL/min
Polishing time: 150 seconds

### (Second step chemical-mechanical polishing)

Chemical mechanical polishing aqueous dispersion:

### Aqueous dispersion (3)

Platen rotation speed: 70 rpm
Head rotation speed: 70 rpm
Head load: 250 g/cm²
Supply rate of aqueous dispersion: 300 mL/min
Polishing time: 45 seconds

### (1-2) Cleaning

After the chemical-mechanical polishing in (1-1) described above, the polished surface of the board was cleaned on a platen under the following conditions and was further cleaned by brush scrub cleaning under the following conditions.

### (Cleaning on a platen)

Cleaning agent: Cleaning composition (6)
Head rotation speed: 70 rpm
Head load: 100 g/cm²
Platen rotation speed: 70 rpm
Supply rate of cleaning agent: 300 mL/min
Cleaning time: 30 seconds

### (Brush scrub cleaning)

Cleaning agent: Cleaning composition (6)
Upper brush rotation speed: 100 rpm
Lower brush rotation speed: 100 rpm
Board rotation speed: 100 rpm
Supply rate of cleaning agent: 300 mL/min
Cleaning time: 30 seconds

### (1-3) Evaluation of the polishing rate and surface defect

The whole surface of the cleaned board was observed using wafer surface contaminant inspection machine "KLA2351" (manufactured by KLA-Tencor Corporation), resulting in 18 surface defects/surface. Dishing in a wire portion 100 µm in width on the board was measured using high-resolution profiler "HRP240" (manufactured by KLA-Tencor Corporation), resulting in 350 Å.

### [Comparative Example 8]

The board having a copper wiring pattern (854LKD003) was chemically-mechanically polished in two steps and was cleaned in two steps in the same manner as in Example 14, except that ultra-pure water was used as a cleaning agent for the cleaning on a platen and the cleaning composition (10) was used for the brush scrub cleaning. The whole surface of the cleaned board was observed in the same manner as in Example 14, resulting in 512 surface defects/surface. Dishing in a wire portion 100 µm in width on the board was measured to be 380 Å.

Cleaning with the conventional cleaning agents (Comparative Examples 1-7) resulted in a large number of surface defects (40 defects or more/surface). In contrast, the cleaning compositions containing the crosslinked organic polymer particles with a small average dispersed particle diameter (Examples 1-13) prevented surface defects (not more than 15 defects/surface). In the invention, the particle diameters of the crosslinked organic polymer particles are smaller than those of the cleaning composition described in Japanese Patent Application Laid-Open No. 2005-255983, whereby the cleaning compositions of the present invention are capable of effective and rapid decontamination of the low dielectric constant films while preventing surface defects.

As demonstrated in Comparative Example 8, when the chemically mechanically polished board having a metal wiring was cleaned with the conventional cleaning agents, a large number of surface defects resulted. In contrast, when the chemically mechanically polished board having a metal pattern was cleaned with the cleaning composition according to the present invention in Example 14, the metal wiring was not adversely affected and the surface defects were prevented.

## Claims

1. A cleaning composition for use after chemical-mechanical polishing, comprising organic polymer particles (A) having a crosslinked structure with an average dispersed particle diameter of 10 nm or more and less than 100 nm and a complexing agent (B).

2. The cleaning composition according to claim 1, wherein the complexing agent (B) is at least one complexing agent selected from the group consisting of organic acids and amino compounds.

3. The cleaning composition according to claim 1 or 2, wherein the complexing agent (B) is at least one complexing agent selected from the group consisting of oxalic acid, malonic acid, succinic acid, tartaric acid, citric acid, ethylenediaminetetraacetic acid, ethylenediaminetetra(methylenephosphonic acid), nitrilotris(methylenephosphonic acid), salts of these acids, glycine, alanine, ethylenediamine, triethanol amine, and ammonia.

4. The cleaning composition according to any one of claims 1 to 3, wherein the organic polymer particles (A) have at least one functional group selected from the group consisting of a carboxyl group, hydroxyl group, amino group, sulfonic acid group, and -N⁺R₃ (wherein R represents a hydrogen atom or an alkyl group with one to four carbon atoms).

5. The cleaning composition according to any one of claims 1 to 4, wherein the organic polymer particles (A) comprise a copolymer of an unsaturated monomer containing a carboxyl group (a1), a multifunctional monomer (a2), and an unsaturated monomer (a3) other than the monomers (a1) and (a2).

6. The cleaning composition according to claim 5, wherein the unsaturated monomer containing a carboxyl group (a1) is (meth)acrylic acid, the multifunctional monomer (a2) is at least one multifunctional monomer selected from the group consisting of divinyl benzene, ethylene glycol dimethacrylate, trimethylol propane tri(meth)acrylate, and pentaerythritol triacrylate, and the unsaturated monomer (a3) is at least one unsaturated monomer selected from the group consisting of styrene, α-methylstyrene, methyl (meth)acrylate, cyclohexyl (meth)acrylate, and phenyl (meth)acrylate.

7. The cleaning composition according to any one of claims 1 to 6, wherein the cleaning composition further comprises a surfactant (C).

8. The cleaning composition according to claim 7, wherein the surfactant (C) is at least one surfactant selected from the group consisting of ammonium lauryl sulfate, dodecylbenzenesulfonic acid, potassium dodecylbenzenesulfonate, ammonium dodecylbenzenesulfonate, tetramethylammonium dodecylbenzenesulfonate, potassium alkylnaphthalenesulfonate, and polyoxyethylene lauryl ether.

9. The cleaning composition according to any one of claims 1 to 8, wherein the cleaning composition further comprises a dispersant (D).

10. The cleaning composition according to claim 9, wherein the dispersant (D) is at least one dispersant selected from the group consisting of poly (meth) acrylic acid and salts thereof, acrylic acid-methacrylic acid copolymer and salts thereof, polyvinyl alcohol, polyvinylpyrrolidone, and hydroxyethyl cellulose.

11. A cleaning method of a semiconductor substrate, comprising cleaning a semiconductor substrate that has been chemically mechanically polished, using the cleaning composition of any one of claims 1 to 10.

12. The cleaning method according to claim 11, wherein the cleaning is at least one type of cleaning selected from the group of cleaning on a platen, brush scrub cleaning, and roll cleaning.

13. A manufacturing method of a semiconductor device, comprising a step of chemically mechanically polishing an untreated semiconductor substrate and a step of cleaning the chemically mechanically polished semiconductor substrate by the cleaning method of claim 11 or 12.

## Patentansprüche

1. Reinigungszusammensetzung zur Verwendung nach chemisch-mechanischem Polieren, die organische Polymerteilchen (A), die eine vernetzte Struktur mit einem mittleren dispergierten Teilchendurchmesser von 10 nm oder mehr und weniger als 100 nm aufweisen, und einen Komplexbildner (B) umfasst.

2. Reinigungszusammensetzung nach Anspruch 1, wobei der Komplexbildner (B) zumindest ein Komplexbildner ist, der aus der Gruppe bestehend aus organischen Säuren und Aminoverbindungen ausgewählt ist.

3. Reinigungszusammensetzung nach Anspruch 1 oder 2, wobei der Komplexbildner (B) zumindest ein Komplexbildner ist, der aus der Gruppe bestehend aus Oxalsäure, Malonsäure, Bernsteinsäure, Weinsäure, Zitronensäure, Ethylendiamintetraessigsäure, Ethylendiamintetra(methylenphosphonsäure), Nitrilotris(methylenphosphonsäure), Salzen dieser Säuren, Glycin, Alanin, Ethylendiamin, Triethanolamin und Ammoniak ausgewählt ist.

4. Reinigungszusammensetzung nach einem der Ansprüche 1 bis 3, wobei die organischen Polymerteilchen (A) zumindest eine funktionelle Gruppe aufweisen, die aus der Gruppe bestehend aus einer Carboxylgruppe, einer Hydroxylgruppe, einer Aminogruppe, einer Sulfonsäuregruppe und -N⁺R₃ (wobei R ein Wasserstoffatom oder eine Alkylgruppe mit einem bis vier Kohlenstoffatomen darstellt) ausgewählt ist.

5. Reinigungszusammensetzung nach einem der Ansprüche 1 bis 4, wobei die organischen Polymerteilchen (A) ein Copolymer eines eine Carboxylgruppe enthaltenden ungesättigten Monomers (a1), ein multifunktionales Monomer (a2), und ein ungesättigtes Monomer (a3), das anderes als die Monomeren (a1) und (a2) ist, umfassen.

6. Reinigungszusammensetzung nach Anspruch 5, wobei das eine Carboxylgruppe enthaltende ungesättigte Monomer (a1) (Meth)Acrylsäure ist, das multifunktionale Monomer (a2) zumindest ein multifunktionales Monomer ist, das aus der Gruppe bestehend aus Divinylbenzol, Ethylenglykoldimethacrylat, Trimethylolpropantri(meth)acrylat und Pentaerythritoltriacrylat ausgewählt ist, und das ungesättigte Monomer (a3) zumindest ein ungesättigtes Monomer ist, das aus der Gruppe bestehend aus Styrol, α-Methylstryol, Methyl(meth)acrylat, Cyclohexyl(meth)acrylat und Phenyl(meth)acrylat ausgewählt ist.

7. Reinigungszusammensetzung nach einem der Ansprüche 1 bis 6, wobei die Reinigungszusammensetzung ferner einen grenzflächenaktiven Stoff (C) aufweist.

8. Reinigungszusammensetzung nach Anspruch 7, wobei der grenzflächenaktive Stoff (C) zumindest ein grenzflächenaktiver Stoff ist, der aus der Gruppe bestehend aus Ammoniumlaurylsulfat, Dodecylbenzolsulfonsäure, Kaliumdodecylbenzolsulfonat, Ammoniumdodecylbenzolsulfonat, Tetramethylammoniumdodecylbenzolsulfonat, Kaliumalkylnaphthalensulfonat und Polyoxyethylenlaurylether ausgewählt ist.

9. Reinigungszusammensetzung nach einem der Ansprüche 1 bis 8, wobei die Reinigungszusammensetzung ferner ein Dispersionsmittel (D) umfasst.

10. Reinigungszusammensetzung nach Anspruch 9, wobei das Dispersionsmittel (D) zumindest ein Dispersionsmittel ist, das aus der Gruppe bestehend aus Poly(meth)acrylsäure und Salzen davon, Acrylsäure-Methacrylsäurecopolymer und Salzen davon, Polyvinylalkohol, Polyvinylpyrrolidon und Hydroxyethylcellulose ausgewählt ist.

11. Reinigungsverfahren eines Halbleitersubstrats, das das Reinigen eines Halbleitersubstrats, das unter Verwendung der Reinigungszusammensetzung nach einem der Ansprüche 1 bis 10 chemisch-mechanisch poliert wurde, umfasst.

12. Reinigungsverfahren nach Anspruch 11, wobei das Reinigen zumindest eine Art von Reinigen ist, das aus der Gruppe bestehend aus Reinigen auf einer Trägerplatte, Scheuerbürstenreinigung und Walzenreinigung ausgewählt ist.

13. Herstellungsverfahren für eine Halbleitereinrichtung, das einen Schritt des chemisch-mechanischen Polierens eines unbehandelten Halbleitersubstrats und einen Schritt des Reinigens des chemisch-mechanisch polierten Halbleitersubstrats durch das Reinigungsverfahren nach Anspruch 11 oder 12 umfasst.

## Revendications

1. Composition de nettoyage à utiliser après un polissage chimique-mécanique, comprenant des particules (A) de polymère organique qui ont une structure réticulée avec un diamètre moyen des particules dispersées de 10 nm ou plus et moins de 100 nm et un agent complexant (B).

2. Composition de nettoyage selon la revendication 1, dans laquelle l'agent complexant (B) est au moins un agent complexant choisi du groupe constitué d'acides organiques et de composés aminés.

3. Composition de nettoyage selon la revendication 1 ou 2, dans laquelle l'agent complexant (B) est au moins un agent complexant choisi du groupe constitué d'acide oxalique, acide malonique, acide succinique, acide tartrique, acide citrique, acide éthylène diamine tétra-acétique, éthylène diamine tétra (acide méthylènephosphonique), nitrilotris (acide méthylène phosphonique), sels de ces acides, glycine, alanine, éthylène diamine, triéthanolamine, et ammoniac.

4. Composition de nettoyage selon l'une quelconque des revendications 1 à 3, dans laquelle les particules (A) de polymère organique ont au moins un groupe fonctionnel choisi du groupe constitué d'un groupe carboxyle, d'un groupe hydroxyle, d'un groupe aminé, d'un groupe acide sulfonique, et de -N⁺R₃ (où R représente un atome d'hydrogène ou un groupe alkyle avec un à quatre atomes de carbone).

5. Composition de nettoyage selon l'une quelconque des revendications 1 à 4, dans laquelle les particules (A) de polymère organique comprennent un copolymère d'un monomère insaturé contenant un groupe carboxyle (a1), un monomère multifonctionnel (a2), et un monomère insaturé (a3) autre que les monomères (a1) et (a2).

6. Composition de nettoyage selon la revendication 5, dans laquelle le monomère insaturé contenant un groupe carboxyle (a1) est un acide (méth)acrylique, le monomère multifonctionnel (a2) est au moins un monomère multifonctionnel choisi du groupe constitué de divinylbenzène, diméthacrylate d'éthylène glycol, tri(méth)acrylate de triméthylolpropane, et triacrylate de pentaérythritol, et le monomère insaturé (a3) est au moins un monomère insaturé choisi du groupe constitué de styrène, α-méthylstyrène, (méth)acrylate de méthyle, (méth)acrylate de cyclohexyle, et (méth)acrylate de phényle.

7. Composition de nettoyage selon l'une quelconque des revendications 1 à 6, dans laquelle la composition de nettoyage comprend en plus un agent tensioactif (C).

8. Composition de nettoyage selon la revendication 7, dans laquelle l'agent tensioactif (C) est au moins un agent tensioactif choisi du groupe constitué de sulfate laurique d'ammonium, acide dodécylbenzènesulfonique, dodécylbenzènesulfonate de potassium, dodécylbenzènesulfonate d'ammonium, dodécylbenzènesulfonate de tétraméthylammonium, alkylnaphthalènesulfonate de potassium, et éther laurique de polyoxyéthylène.

9. Composition de nettoyage selon l'une quelconque des revendications 1 à 8, dans laquelle la composition de nettoyage comprend en plus un dispersant (D).

10. Composition de nettoyage selon la revendication 9, dans laquelle le dispersant (D) est au moins un dispersant choisi du groupe constitué d'acide poly(méth)acrylique et sels correspondants, copolymère d'acide acrylique et d'acide méthacrylique et sels correspondants, alcool polyvinylique, polyvinylpyrrolidone, et cellulose hydroxyéthylique.

11. Procédé de nettoyage d'un substrat semi-conducteur, comprenant le nettoyage d'un substrat semi-conducteur qui a été chimiquement et mécaniquement poli, en utilisant la composition de nettoyage de l'une quelconque des revendications 1 à 10.

12. Procédé de nettoyage selon la revendication 11, dans lequel le nettoyage est au moins un type de nettoyage choisi parmi le groupe de nettoyage sur platine, nettoyage à la brosse; et nettoyage au rouleau.

13. Procédé de fabrication d'un dispositif semi-conducteur, comprenant une étape qui consiste à polir chimiquement et mécaniquement un substrat semi-conducteur non traité et une étape qui consiste à nettoyer le substrat semi-conducteur poli chimiquement et mécaniquement par le procédé de nettoyage de la revendication 11 ou 12.
